# EUROPEAN PATENT APPLICATION

(11) **EP 2 009 381 A2**
(43) Date of publication of application: **31.12.2008**
(21) Application number: 08158748.7
(22) Date of filing: 23.06.2008
(51) Int. Cl.: F28D 7/00, F28F 1/02, F28F 3/12

(54) **Cooling element**

(30) Priority: 29.06.2007 FI 20075497
(71) Applicant: ABB Oy, 00380 Helsinki (FI)
(72) Inventor: Seväkivi, Pertti, 01830 Lepsämä (FI); Tiihonen, Vesa, 01620 Vantaa (FI)
(74) Representative: Holmström, Stefan Mikael

(57) **Abstract**

The present invention relates to a cooling element (1) comprising a frame part provided with at least one cooling channel (2) for supplying a medium that cools down the cooling element through the cooling element. To provide a more efficient cooling element, the frame part comprises a first curved surface (3) and the frame part is provided with a bending point (5), at which the frame part may be bent to change the curvature of said first curved surface (3).

## Description

### FIELD OF THE INVENTION

The present invention relates to a cooling element, the structure of which ensures that a contact area between the cooling element and an object to be cooled is sufficiently large.

### DESCRIPTION OF PRIOR ART

In cooling an object efficiently, the contact surface between the object to be cooled and a cooling element plays an important role. The contact surface should be as large as possible so that the generated heat could be transferred as efficiently as possible from the object to be cooled to the cooling element.

In objects to be cooled which do not comprise a planar surface that comes into contact with the cooling element, e.g. manufacturing tolerances may cause that a gap is formed between the cooling element and the object to be cooled in a region intended to be the contact surface. Such a gap is also formed, for instance, when a coil is wound around a cooling element with a rectangular cross-section, because due to the angularity of the cooling element the coil cannot follow the shape of the cooling element closely along its whole length. Because of the above-mentioned gap, the contact area becomes smaller and the cooling power decreases.

### SUMMARY OF THE INVENTION

It is an object of the present invention to solve the above-mentioned problem and provide a new cooling element, by which a more efficient cooling may be achieved. This object is achieved by the cooling element according to the independent claim 1.

According to the invention, a cooling element is utilized, the frame part of which comprises a curved surface and a bending point, by which the curvature of the curved surface may be changed. The shape of the cooling element may thus be arranged to correspond to the surface shape of the object to be cooled, which makes the cooling area as large as possible. The radius of curvature of the curved surface need not be the same along the entire region of the curved surface, but it is possible that the radius of curvature varies depending on the shape of the object to be cooled and that the curved surface even has planar sections that separate the curved sections.

The preferred embodiments of the cooling element according to the invention are disclosed in the attached dependent claims.

### BRIEF DESCRIPTION OF THE FIGURES

The invention will now be described by way of example and in greater detail with reference to the attached figures, in which
Figures 1 and 2 illustrate a first preferred embodiment of a cooling element of the invention,
Figure 3 illustrates a second preferred embodiment of the cooling element of the invention, and
Figure 4 illustrates a third preferred embodiment of the cooling element of the invention.

### DESCRIPTION OF AT LEAST ONE EMBODIMENT

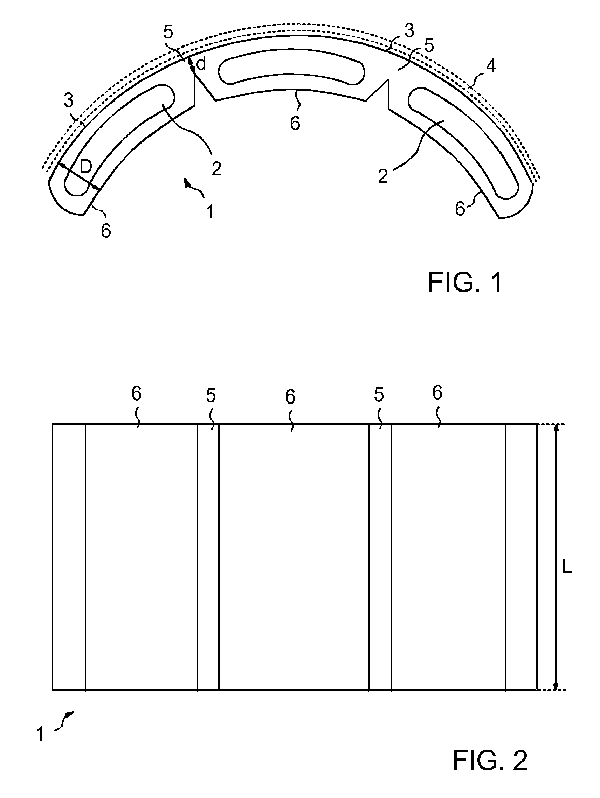

Figures 1 and 2 illustrate a first preferred embodiment of a cooling element 1 of the invention. Figure 1 shows the cooling element from an end, and Figure 2 shows the side of the cooling element 1 that is facing downwards in Figure 1. The frame part of the cooling element 1 is provided with at least one cooling channel 2, through which a cooling medium, such as air or a liquid, may be supplied. To supply the medium into and out of the cooling channel, suitable connectors are attached to the cooling channel 2.

The frame part of the cooling element 1 is provided with a first curved surface 3, which in Figure 1 is a convex surface. In order for the first surface 3 to follow the shape of the object 4 to be cooled as closely as possible, the frame part is provided with a bending point 5 (in Figures 1 and 2 there are two bending points), at which the frame part may be bent such that the curvature of the first curved surface 3 changes. In the example of Figures 1 and 2, the bending points 5 are provided with grooves, which extend along the entire length L of the frame part and at which the thickness d of the frame part is smaller than the thickness D of the frame part in other parts.

In the example of Figures 1 and 2, a second surface 6 of the frame part, facing downwards in Figure 1, is also curved. However, this is not necessary in all embodiments, but the shape of the second surface may vary depending on the application.

The cooling element of Figures 1 and 2 may be manufactured from aluminium by extrusion, for instance. In this case, the frame part may be directly provided with cooling channels 2 and grooves 5 at the extrusion stage, and the surfaces 3 and 6 may be directly provided with a desired shape. This means that the need for machining the frame part of the cooling element 1 can be minimized or, in the best case, entirely eliminated. This allows the utilization of a softer aluminium alloy in the manufacture of the cooling element. The bending points 5 are preferably shaped so flexible, i.e. in Figures 1 and 2 their material thickness is so small, that the cooling element automatically adapts to the shape of the object to be cooled, when the cooling element and the object to be cooled are pressed against each other.

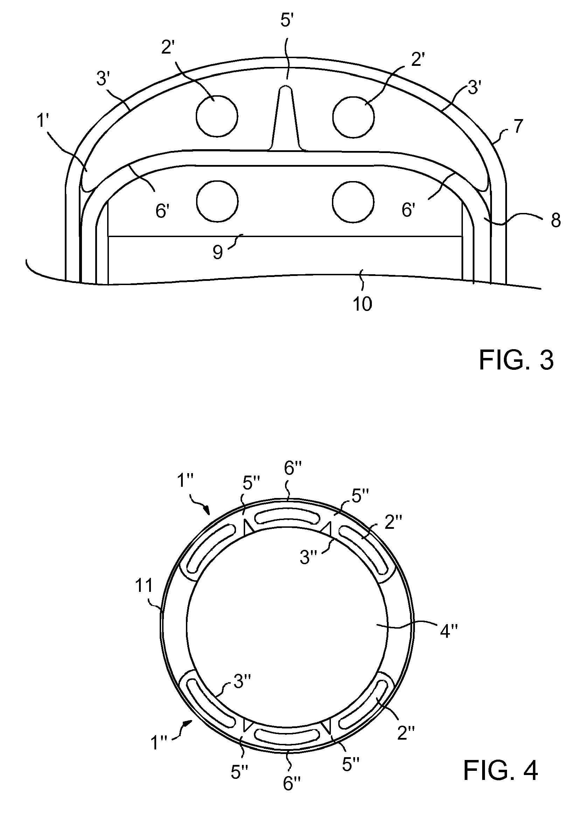

Figure 3 illustrates a second preferred embodiment of the cooling element 1' of the invention. Figure 3 shows the cooling element from an end, whereby its cooling channels 2' can be seen. The cooling element of Figure 3 is a cooling element of a coil, such as a choke coil. The cooling element 1' may be manufactured similarly as described in connection with Figure 1.

Also in the cooling element 1' of Figure 3 the first surface 3' is convex. A coil 7, which is wound around at least the cooling element 1', is pressed against the convex first surface 3'. Because of the groove at the bending point 5', the frame part of the cooling element 1' at the bending point is sufficiently flexible to make the force applied by the coil 7 to the cooling element 1' change the shape of the first curved surface 3' so that it closely follows the shape of the coil 7. As large a cooling area as possible is thereby created between the coil 7 and the first curved surface 3', through which the generated heat can be transferred from the coil 7 to the cooling element 1'.

Figure 3 shows that the second curved surface 6' of the cooling element 1' is also in contact with the coil. More specifically, the cooling element is located between different layers 7 and 8 of the coil, whereby the first convex surface 3' cools down the coil layer 7 and the second concave surface 6' cools down the coil layer 8.

The structure of Figure 3 also comprises a second cooling element 9, the curved upper surface of which is in contact with the coil layer 8 and the smooth lower surface of which is in contact with an iron core 10 of the coil. Such a structure may provide a very efficient cooling for the coil and its iron core. For simplicity, Figure 3 does not show the lower half of the coil and the iron core, which may comprise a second cooling element 1' and a cooling element 9 arranged similarly as in the shown, upper half.

Figure 4 illustrates a third preferred embodiment of the cooling element of the invention. Figure 4 shows two cooling elements 1" arranged around a cylindrical object 4" to be cooled. This object to be cooled may be, for instance, a capacitor 4", against the outer surface of which the cooling elements 1" are pressed by means of a clamping band 11. The grooves at the bending points 5" of the frame parts of the cooling elements make the frame parts bend in such a manner that their first concave surfaces 3" follow the shape of the outer surface of the object 4" closely. Due to the fastening means of the cooling elements 1", the second surfaces 6" thereof are also curved, in this case convex, but if the fastening means differs from the example, these second surfaces need not necessarily be curved.

It is to be understood that the above specification and the related figures are only intended to illustrate the present invention. Different variations and modifications of the invention will be obvious to a person skilled in the art without deviating from the scope of the invention.

## Claims

1. A cooling element (1, 1', 1") comprising
a frame part provided with at least one cooling channel (2, 2', 2") for supplying a medium that cools down the cooling element through the cooling element, **characterized in that**
the frame part is manufactured from aluminium by extrusion, whereby at the extrusion stage the frame part is provided with
a first curved surface (3, 3', 3"),
said at least one cooling channel (2, 2', 2"), and
a bending point (5, 5', 5"), at which the frame part may be bent to change the curvature of said first curved surface (3, 3', 3"), whereby said bending point comprises a groove, which extends along the entire length (L) of the frame part and at which the thickness (d) of the frame part is smaller than elsewhere.

2. A cooling element as claimed in claim 1, **characterized in that**
said first curved surface (3, 3') is convex, and
the cooling element is a cooling element of a coil (7, 8), and said coil is wound around at least the frame part and arranged to come into contact with at least said first convex surface (3, 3').

3. A cooling element as claimed in claim 2, **characterized in that**
the frame part comprises a second curved surface (6'), which is convex, and
the cooling element (1') is arranged between the different layers (7, 8) of the coil, and said coil comes into contact with both the convex surface (3') and the concave surface (6').

4. A cooling element as claimed in any one of claims 1 to 3, char- acterized in that said cooling element (1') is a cooling element of a choke coil (7, 8).

5. A cooling element as claimed in claim 1, **characterized in that**
said first curved surface (3") is concave, and
the cooling element (1") is a cooling element of a cylindrical object (4"), and the first concave surface (3") of the frame part is arranged against the cylindrical surface of the cylindrical object (4").

6. A cooling element as claimed in claim 5, **characterized in that** said cooling element (1 ") is a cooling element of a capacitor.
